# EUROPEAN PATENT APPLICATION

(11) **EP 1 480 227 A1**
(43) Date of publication of application: **24.11.2004**
(21) Application number: 03101472.3
(22) Date of filing: 22.05.2003
(51) Int. Cl.: G11C 29/00

(54) **Testing integrated circuits with fault dictionary**

(71) Applicant: Koninklijke Philips Electronics N.V., 5621 BA Eindhoven (NL)
(72) Inventor: The designation of the inventor has not yet been filed
(74) Representative: Slenders, Petrus Johannes Waltherus

(57) **Abstract**

A method and apparatus for diagnosing resistive open defects in address decoders and, in particular memory address decoders. The method and apparatus accelerate the diagnosis process of detecting any resistive open defects that may occur during production, particularly where time-to market is a very important factor. Based on the disclosed invention, many actions for improving yield can be taken. In accordance with the invention, there is created a fault dictionary of resistive-open defects based on defect location, transistor types, terminal names and also the fault behavior. The dictionary enhances the diagnosing capabilities and also helps in differentiating between resistive bridge and resistive open defects.

## Description

This invention relates to a method and apparatus for testing an integrated circuit, such as a semiconductor memory address decoder, and more particularly, to a method and apparatus for testing such circuits for the presence of open defects.

Systematic and automatic testing of electronic circuitry, and of integrated circuits in particular, is becoming increasingly important. Each generation of circuit tends to comprise ever higher component densities and an increasing number of system functionalities. Individual circuits have become complicated to such an extent that process defects cannot be detected and located, except by means of exhaustive and expensive testing. It will be appreciated that customers cannot be expected to accept circuitry products that only reveal their hidden defects during operational use, thereby rendering, for example, life support systems or aircraft control systems unreliable. It is therefore of the utmost importance to both the manufacturer and the customer that tests are performed so as to ensure flawless operation of the circuitry products.

Random access memories (SRAMs, DRAMS) occupy a strategic position in the microelectronics industry. In many respects, RAM testing is different from conventional logic testing. RAMs tend to be the largest and densest circuits produced, and their small feature size and huge chip size result in an enormous critical area for defects. High complexity and defect sensitivity have pushed RAM testing costs to the extreme, and a variety of solutions to this problem have been proposed.

Random access memories are usually subjected to March tests and/or Data Retention tests. In a March test, individual march elements traverse all RAM addresses and perform a specified combination of read and write operations. For example, a typical march element first reads each RAM address location and then writes back the complement of expected data values. Together, all of the march elements should cover all of the likely faults in a given RAM.

After compiling the likely faults into a RAM fault model, a test engineer will develop a test algorithm to cover it. The total number of memory operations performed by all march elements for a given RAM address determines a test algorithm's overall complexity. The complexity of march test algorithms is linear with respect to the address space; hence, they are also known as linear algorithms.

Conventionally, it has been suggested that RAM decoder defects can be mapped as RAM array faults and detected by testing the RAM array, such that in the past it has been assumed that circuits such as address decoders need no special testing. However, it has since been discovered that some open defects can occur in circuits such as RAM address decoders which are not detectable by means of march tests.

Open defects, or stuck-open transistor faults, cause sequential behavior in CMOS circuits and require a two-pattern test sequence for their detection. Open defects in RAM matrices appear as cell read failures, row/column read failures, or cell stuck-at (SA) faults, all of which are detectable by march tests. However, march tests fail to detect one class of open defects in circuits such as address decoders.

Generally, a missing contact, thinner metal, larger numbers of vias, poly breaks, the scaling of the devices and the increase in complexity of the fabrication process all result in an increased number of open defects in CMOS technology. The probability of the occurrence of open defects is further increasing with the move from aluminium to copper in lower technology (from CMOS12 and below).

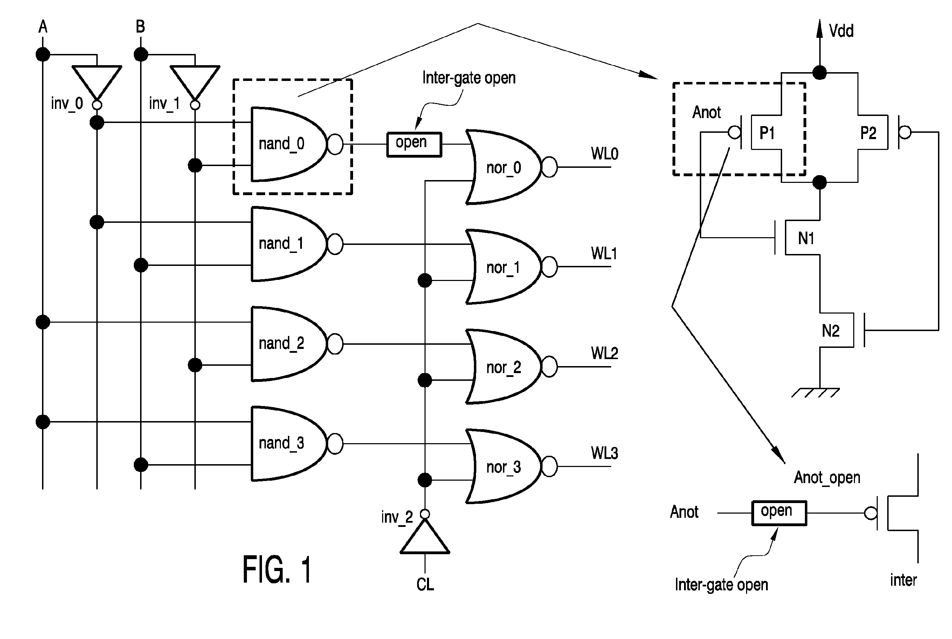

Referring to Figure 1 of the drawings, open defects can be classified into two classes, as follows:
- Inter-gate defects, which occur between different gates of an address decoder and tend to cause stuck-at or logical delay behavior; the stuck-at behavior can normally be detected by the conventional march tests; however, logical delay behavior cannot.
- Intra-gate defects, which occur within the different gates of an address decoder and tend to cause sequential or sequential delay behavior; these types of defects are not completely covered by traditional march tests, and hence require special multiple test pattern sequences.

A method of testing a memory address decoder is disclosed in European Patent Number EP-B-0738418. The method disclosed in this document involves writing complementary logic data to two respective cells of two logically adjacent rows or columns. If a subsequent Read operation reveals the data in the two cells to be identical, the presence and location of a hard-open defects in the decoders is demonstrated. In more detail, the method disclosed in EP-B-0738418 uses a systematic approach in which a first logic state is written to the first cell and then a second logic state, complementary to the first, is written to the second cell. Reading the first cell after completion of the write operation of the Write operation conducted on the second cell should reveal that the first cell is still in the first logic state if the decoding means is functioning correctly. However, if the first cell turns out to have assumed the second logic state, then the first cell was overwritten during the Write operation of the second cell, thereby enabling the detection and location of a defect in the decoding means.

The exploding telecommunications market, as well as markets for consumer and automotive electronics, has resulted in a rapidly increasing number of mixed-signal devices being produced. In the production of mixed-signal circuits, test can be a limiting factor contributing significantly to the manufacturing cost. Compared with digital testing, the lack of a systematic approach to mixed-signal testing development in the IC industry has, in the past, resulted in relatively poor test coverage, high test costs, and long test-development time. In order to solve these problems, a structured test method called Defect-Oriented Testing (DOT) has been proposed for analogue circuits and studied in recent years. The presented results in the literature show that DOT is promising structural method to optimize test vectors with high fault coverage and low test-application costs. However, there were still some problems to be solved before this method could be used in the IC industry. For instance, it was necessary to develop a proper fault model, speed up fault simulation, and simulate the digital and analogue parts of the circuit in a single simulator. The problem of how to reduce the fault simulation time is one of the most important issues governing the use of this method in industry.

One solution which has been proposed to reduce fault simulation time is to use high-level models in the fault simulation. In this approach, during fault simulation, the fault-free blocks are simulated with high-level models to reduce the simulation time. The faulty blocks are simulated at transistor level for easy and accurate injection of the faults. Crucial for this method is, of course, the generation of the suitable high-level models of the blocks.

There are already some known methods to generate high-level models in the IC design field. However, in analogue fault simulation, the faulty block can have unexpected behavior. Therefore, it is possible that the normal high-level models, which are generated with fault-free surrounding blocks, cannot work properly in the fault simulation environment. It is also possible that they can mask the fault, i.e. the fault cannot be detected due to the usage of the high-level model. So, the high-level model used in fault simulation has different requirements as compared to the high-level model usually used in IC design.

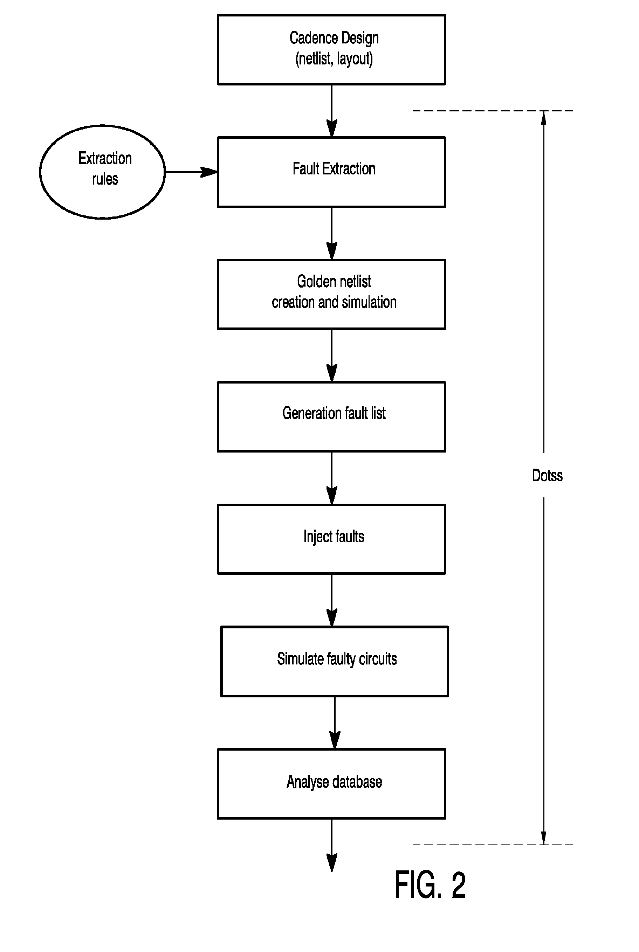

A Defect-Oriented Test Simulation System (DOTSS) has been proposed which is a tool that supports DOT methodology for medium-sized building blocks using a form of Inductive Fault Analysis (IFA). It is an environment for mixed-signal fault simulation and test optimization. An overview of the DOTSS procedure flow is illustrated in Figure 2 of the drawings. Starting from the layout of the design, DOTSS generates a list of faults that may occur during IC production and inserts them one-by-one in the original design. DOTSS then simulates these faulty netlists together with a user-defined set of tests. It subsequently quantifies the fault coverage and optimizes the test sequences with the user-defined test cost of individual test. Thus, it allows designers and test engineers to make a quick and accurate assessment of the test coverage of realistic process defects before any silicon is produced.

Nowadays, fault diagnosis in semiconductor memories is becoming a difficult problem because of the advances on miniaturization of the transistors. Locating the defects, or locating precisely the defect position of a failing transistor in a sea of transistors is recognized to be a difficult problem. For semiconductor memories, bit mapping is widely used to locate the failing bits, however, the precise defect location remains unknown. Therefore the defect cause can rarely be explained.

In a production environment, when the yield drops down, it becomes essential to resolve the failure as soon as possible, particularly in the case of the semiconductor industry, where time-to-market (TTM) plays an important role. Diagnosing the cause of the defect in memories without the help of appropriate CAD tools becomes increasingly more time consuming and expensive. This may contribute significantly to any delay in the time-to-market of a product.

We have now devised an improved arrangement.

In accordance with the present invention, there is provided a method for generating a fault dictionary for use in testing an electronic circuit comprising a plurality of cells for receiving logic data, the method comprising the steps of injecting defects into a plurality of terminals of said electronic circuit, providing an input stimulus to said electronic circuit and obtaining simulated output data from said electronic circuit including said effects, comparing said simulated output data with output data representative of the correct operation of said electronic circuit in the absence of any defects, identifying said defects by identifying any mismatch between said simulated output data and the correct output data, and storing identifying data relating to said defects together with data representing the behavior of said electronic circuit caused by said respective defects.

Also in accordance with the present invention, there is provided apparatus for generating a fault dictionary for use in testing an electronic circuit comprising a plurality of cells for receiving logic data, the apparatus comprising means for injecting defects into a plurality of terminals of said electronic circuit, means for providing an input stimulus to said electronic circuit and obtaining simulated output data from said electronic circuit including said effects, means for comparing said simulated output data with output data representative of the correct operation of said electronic circuit in the absence of any defects, and means for identifying said defects by identifying any mismatch between said simulated output data and the correct output data, and storing identifying data relating to said defects together with data representing the behavior of said electronic circuit caused by said respective defects.

Still further in accordance with the present invention, there is provided a fault dictionary for use in testing an electronic circuit comprising a plurality of cells for receiving logic data, the fault dictionary comprising a data set identifying a plurality of defect types which may occur in said electronic circuit, and corresponding data relating to the resultant faulty behavior of said electronic circuit as a result of the occurrence of a respective defect.

Beneficially, the fault dictionary is created by comparing the golden and faulty netlists generated by a Defect Oriented Test Simulation System, and identifying said faulty behavior accordingly.

In a preferred embodiment, the fault dictionary includes (for each identified defect) one or more of the following entries, preferably in the form of a look-up table or the like: a code identifying a defect and its location within said fault dictionary, the component affected by said defect, the terminal of said electronic circuit affected by said defect, a code assigned to said defect, and a description of the behavior of said electronic circuit as a result of said defect.

The present invention extends to a method of testing an electronic circuit comprising a plurality of cells for receiving logic data, the method comprising the steps of providing an input stimulus to said electronic circuit and obtaining corresponding output data from said electronic circuit as a result of operation thereof, so as to identify any faulty behavior of said electronic circuit over one or more clock cycles, the method being characterized by the step of employing a fault dictionary as defined above to look up said faulty behavior and identify the nature and location of one or more defects causing said faulty behavior.

The present invention further extends to apparatus for testing an electronic circuit comprising a plurality of cells for receiving logic data, the apparatus comprising means for providing an input stimulus to said electronic circuit and obtaining corresponding output data from said electronic circuit as a result of operation thereof, so as to identify any faulty behavior of said electronic circuit over one or more clock cycles, the apparatus being characterized by means for accessing a fault dictionary as defined above to look up said faulty behavior and identify the nature and location of one or more defects causing said faulty behavior.

These and other aspects of the present invention will be apparent from, and elucidated with reference to, the embodiment described hereinafter.

An embodiment of the present invention will now be described by way of example only and with reference to the accompanying drawings, in which:
Figure 1 is a schematic circuit diagram of a conventional address decoder illustrating inter-gate and intra-gate open defects;
Figure 2 is a flow diagram illustrating schematically the operation of a Defect-Oriented Test Simulation System;
Figure 3 is a flow diagram illustrating schematically a method of generating a fault dictionary in accordance with an exemplary embodiment of the present invention;
Figures 4 A and B illustrate simulation waveforms for golden and faulty netlists respectively; and
Figures 5A and B illustrate graphically the typical behavior of bridge and open defects respectively.

Thus, the present invention involves the creation and use of a fault dictionary for an electronic circuit, such as a memory address decoder, which will facilitate the diagnosing capability quickly and more precisely In this exemplary embodiment of the invention, the fault dictionary is a database where the necessary information regarding the defect location and the faulty behavior are stored using unique codes for each special faulty behavior. Looking at the test results (from a simulation system) during diagnosis, the defect location can be relatively easily determined with the help of the fault dictionary.

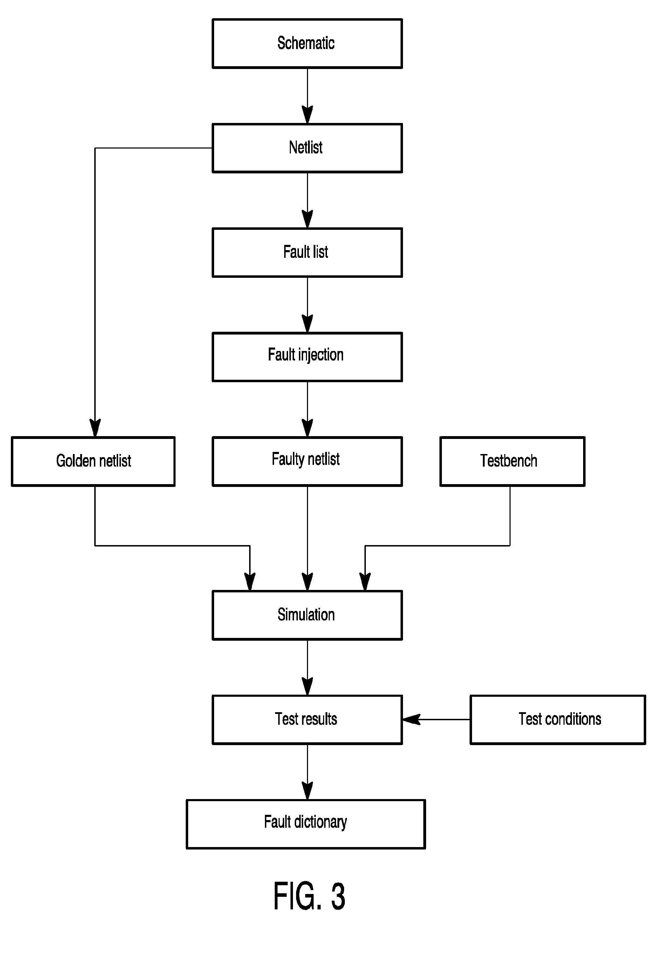

In this exemplary embodiment of the present invention, the fault dictionary is created using an automated flow which extracts the open defects from all terminals of the netlist, and generates a fault list which contains the transistor and terminal information. A global overview of an exemplary method of generating a fault dictionary in accordance with the present invention is illustrated in Figure 3 of the drawings.

As illustrated, in this exemplary embodiment of the present invention, a Defect-Oriented Test Simulation System (DOTSS) is used to inject open defects in the circuit netlist so as to generate faulty netlists. The open defects, in this case, are the resistive components with any resistance (0 < R < :), injected at all possible locations within the address decoder. No layout information is required to be used in this case, because all possible opens are considered at transistor level. The test bench (input stimulus) is created for analogue simulation is which based on the march test and dedicated test patterns to detect stuck-open address decoder faults. The test results are analyzed and described in a fault dictionary. This dictionary summarizes the defect location and the faulty behavior of the injected open defects.

The dictionary is based on the analysis of the golden and faulty simulation waveforms looking into the internal word lines. In this exemplary embodiment, the observed mismatch between the golden and faulty simulations is used as the focus of attention. When a correct input stimulus is applied, a mismatch between the golden and faulty wordlines is observed, and the faulty behavior is propagated to the memory outputs. Thus, if the read and expected logic values mismatch, then the open defect is detected and fault coverage can be estimated.

All types of faulty behavior (in this embodiment) can be characterized into six classes which are described in the following table:

| # Defect | # Transistor | Terminal | Code | Description |
|---|---|---|---|---|
| Def-1 | N2.nand_0 | Source | SA0 | Wordline-0 is stuck at 0 |
| Def-2 | N1.inv_0 | Drain | SMA-5T | (WL2,WL0) and (WL3,WL1) are simultaneously accessed during 5 clock cycles |
| Def-3 | P1.inv_0 | Source | SEL-UNSEL | WL0, WL1 selected for one clock cycle, remains unselected afterwards |
| Def-4 | N2.nand_1 | Gate | UNSEL-2T | WL1 is unselected for 2 clock cycles |
| Def-5 | N1.nand_3 | Gate | STR-2T | WL3 slow-to-rise for 2 clock cycles |
| Def-6 | N2.nor_0 | Drain | STF-5T | WL0 slow-to-fall for 5 clock cycles |

The first column # Defect indicates the defect number and also the corresponding location in the data base where the simulation waveforms are stored. The transistor number is given in the second column #Transistor. The third column, Terminal, denotes the name of the transistor terminal. The fourth and fifth columns give the assigned code and description respectively of the faulty behavior.

The above table shows only a subset of the complete fault dictionary which comprises all detected open defects. In the following, an explanation of the table and the different faulty behaviors are given. The code *SA0* means that a determined wordline is stuck at 0 while *SMA-nT* means that two or many wordlines are simultaneously accessed during n clock cycles. The code *SEL-UNSEL* means that a wordline is selected during one clock cycle and remains unselected afterwards. The code *UNSEL-nT* means that a wordline is unselected during *n* clock cycles. The codes *STR-nT (STF-nT)* mean that a wordline behaves as a slow-to-rise (slow-to-fall) during *n* clock cycles.

For instance, the first row of the above table indicates that the waveforms of the injected defect is stored in the database *Def-1.* This corresponds to the open defect that have been injected in the source of the second NMOS transistor of the NAND gate *nand-0* (see Figure 1). The faulty behavior shows that the wordline WL0 is stuck at 0 (SA0). The second row represents the second open defect which has been injected at the drain of the NMOS transistor in the inverter *inv-0.* The faulty behavior shows that the wordlines (WL2, WL0) and (WL3, WL1) are simultaneously accessed during five clock cycles. The third row represents the injected open defect at the source of the PMOS in the inverter *inv-0,* and shows that the wordlines WL0 and WL1 are selected during one clock cycle and remain unselected afterwards. The fourth row indicates the open defect injected at the gate of the second NMOS transistor in the NAND gate *nand-1.* The faulty behavior shows that wordline WL1 remains unselected during two clock cycles. Finally, the last two rows show a slow-to-rise and slow-to-fall faulty behavior during two and five clock cycles, respectively.

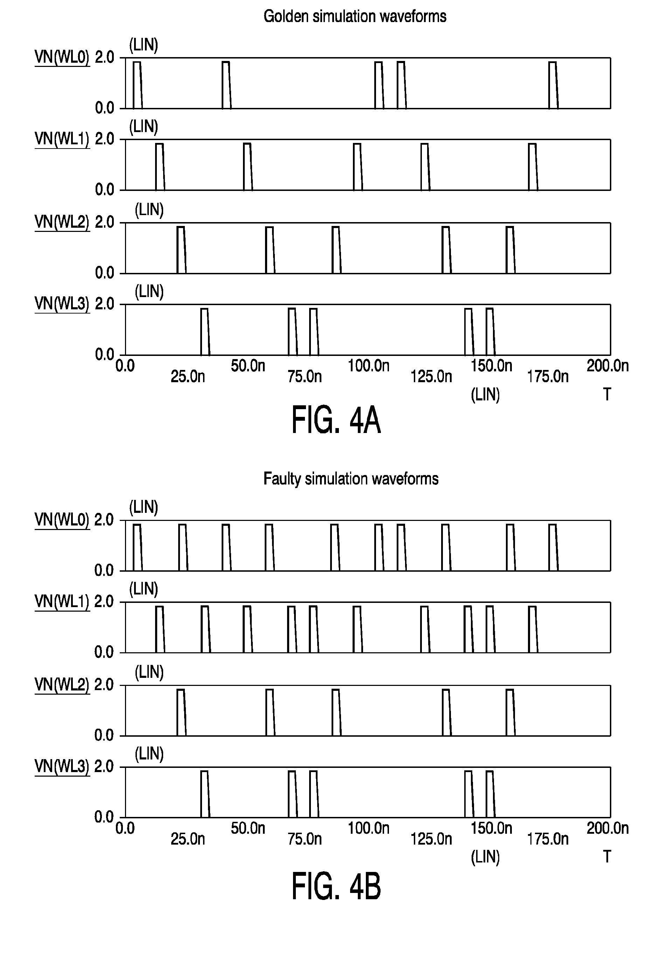

For example, the simulation waveforms of the golden and faulty netlists with respect to *Def-2* are shown in Figures 4A and 4B. For analogue simulation, a march test of 11N is used in the testbench which consists of five march elements with the corresponding address order (⇑⇑ 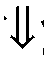 ⇑ 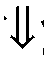 ). The golden simulation is shown in Figure 4A which clearly represents the five address sequences of the march test. Figure 4B shows the faulty simulation waveforms with respect to *Def-2,* and represents the simultaneous access of the wordlines (WL2, WL0) and (WL3, WL1). It can be observed from the faulty simulation that the wordline WL2 (WL3) enables the wordline WL0 (WL1) during five clock cycles. The consequence of this defect leads to simultaneous access of two memory positions during the same clock cycles.

One of the main goals of creating the faulty dictionary is to help in diagnosing the defects. To be specific, it can definitely be used to differentiate the faulty behavior between bridges and opens. In previous experiments using the bridge fault model, it was concluded that defining the faulty behavior of defect is very important for diagnosis. For ease of comparison, consider the case where resistive bridge is injected between *WL*_{*i*} and *WL.*_{*j*} The simulation waveforms show that both shorted wordlines are simultaneously accessed during all clock cycles. However, in the presence of an open defect (Refer to *Def-2* in Table 1) the same wordlines are simultaneously enabled only when the aggressor wordlines are enabled. In the case of *Def-2* the aggressor wordlines are WL2 and WL3, while the victims are WL0 and WL1, respectively (see Figure 4).

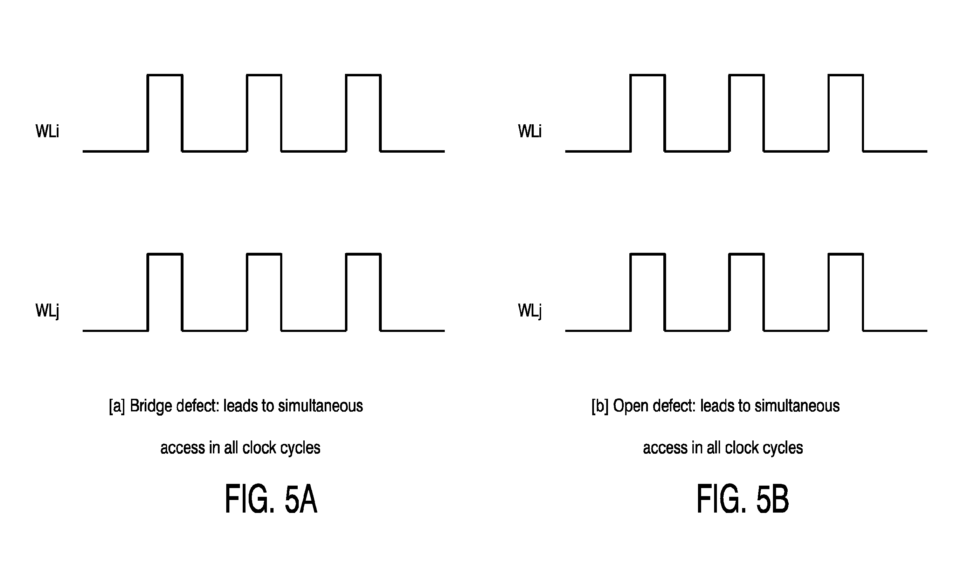

An explanation of the faulty behavior of the bridge and the open defect is elaborated in Figure 5. It is highlighted in Figure 5A that both wordlines are enabled simultaneously whenever any one of the wordline is enabled in the case of a bridge defect. However, Figure 5B shows clearly that the wordline *WL*_{*j*} invokes *WL*ᵢ only during one clock cycle. The output response of the memory during the application of the march test 11N on the tester gives the *AND logic* or the *OR logic* of the memory contents of the positions corresponding to the addressed locations. Hence, on the application of the march test 11N, the bridge defect will be detected in both address order (increasing and decreasing), however, the open defect will be detected either in increasing or decreasing address order.

Thus, the present invention provides a solution to the problems outlined above by creating a fault dictionary for an electronic circuit, such a memory address decoder, which will facilitate the diagnosing capability quickly and more precisely that any prior art systems. In the given example, the fault dictionary comprises a database where the necessary information regarding the defect location and the faulty behavior are stored using unique codes for each special faulty behavior. Looking at the test results from a simulation system during testing, the faults can be relatively easily diagnosed and located using the fault dictionary. The present invention therefore significantly increases the diagnostic resolution of resistive open defects in circuits, such as a memory address decoder. In addition, it accelerates the diagnosis process, which in turn, enhances yield by providing an opportunity for modification of a design or process related problem.

An embodiment of the present invention has been described above by way of example only, and it will be apparent to a person skilled in the art that modifications and variations can be made to the described embodiment without departing from the scope of the invention as defined in the appended claims. Furthermore, it will be appreciated that the term "consisting" used herein does not exclude other elements or steps, "a" or "an" does not exclude a plurality, and a single processor or other unit may fulfill the functions of several means recited in the claims.

## Claims

1. A method for generating a fault dictionary for use in testing an electronic circuit comprising a plurality of cells for receiving logic data, the method comprising the steps of injecting defects into a plurality of terminals of said electronic circuit, providing an input stimulus to said electronic circuit and obtaining simulated output data from said electronic circuit including said effects, comparing said simulated output data with output data representative of the correct operation of said electronic circuit in the absence of any defects, identifying said defects by identifying any mismatch between said simulated output data and the correct output data, and storing identifying data relating to said defects together with data representing the behavior of said electronic circuit caused by said respective defects.

2. A method according to claim 1, wherein said fault dictionary is created by comparing the golden and faulty netlists generated by a Defect Oriented Test Simulation System, and identifying said faulty behavior accordingly.

3. Apparatus for generating a faulty dictionary for use in testing an electronic circuit comprising a plurality of cells for receiving logic data, the apparatus comprising means for injecting defects into a plurality of terminals of said electronic circuit, means for providing an input stimulus to said electronic circuit and obtaining simulated output data from said electronic circuit including said effects, means for comparing said simulated output data with output data representative of the correct operation of said electronic circuit in the absence of any defects, and means for identifying said defects by identifying any mismatch between said simulated output data and the correct output data, and storing identifying data relating to said defects together with data representing the behavior of said electronic circuit caused by said respective defects.

4. Apparatus according to claim 3, comprising a Defect Orientated Test Simulation System.

5. A fault dictionary for use in testing an electronic circuit comprising a plurality of cells for receiving logic data, the fault dictionary comprising a data set identifying a plurality of defect types which may occur in said electronic circuit, and corresponding data relating to the resultant faulty behavior of said electronic circuit as a result of the occurrence of a respective defect.

6. A fault dictionary according to claim 5, which includes (for each identified defect) one or more of the following entries, preferably in the form of a look-up table or the like: a code identifying a defect and its location within said fault dictionary, the component affected by said defect, the terminal of said electronic circuit affected by said defect, a code assigned to said defect, and a description of the behavior of said electronic circuit as a result of said defect.

7. A method of testing an electronic circuit comprising a plurality of cells for receiving logic data, the method comprising the steps of providing an input stimulus to said electronic circuit and obtaining corresponding output data from said electronic circuit as a result of operation thereof, so as to identify any faulty behavior of said electronic circuit over one or more clock cycles, the method being **characterized by** the step of employing a fault dictionary according to claim 5 or 6 to look up said faulty behavior and identify the nature and location of one or more defects causing said faulty behavior.

8. Apparatus for testing an electronic circuit comprising a plurality of cells for receiving logic data, the apparatus comprising means for providing an input stimulus to said electronic circuit and obtaining corresponding output data from said electronic circuit as a result of operation thereof, so as to identify any faulty behavior of said electronic circuit over one or more clock cycles, the apparatus being **characterized by** means for accessing a fault dictionary according to claim 5 or claim 6 to look up said faulty behavior and identify the nature and location of one or more defects causing said faulty behavior.
